# EUROPEAN PATENT APPLICATION

(11) **EP 4 439 415 A1**
(43) Date of publication of application: **02.10.2024**
(21) Application number: 23305461.8
(22) Date of filing: 31.03.2023
(51) Int. Cl.: G06Q 10/06, G06F 16/21

(54) **PLANT INFRASTRUCTURE MODELLING UPDATE FROM ENGINEERING INFORMATION**

(71) Applicant: SCHNEIDER ELECTRIC INDUSTRIES SAS, 92500 Rueil-Malmaison (FR)
(72) Inventor: FARRUGIA, Philippe, 06220 Vallauris (FR)
(74) Representative: Schneider Electric

(57) **Abstract**

The invention relates to an application server (AS) for updating a semantic model of a plant infrastructure comprising physical assets that belong to different engineering domains, wherein applications are dedicated to the engineering domains, wherein physical assets are represented respectively by first logical assets in updated applications and respectively by second logical assets in outdated applications, configured to:
determine, for at least one updated application, first logical attributes and corresponding first logical values of a first logical asset from first metadata associated with the first logical asset,
determine, for at least one outdated application, second logical attributes and corresponding second logical values of a second logical asset from second metadata associated with the second logical asset,
determine a first semantic asset with first semantic attributes and corresponding first semantic values using pattern-matching rules related to the semantic model on the first logical attributes and corresponding first logical values, and determining a second semantic asset with second semantic attributes and corresponding second semantic values using pattern-matching rules related to the semantic model on the second logical attributes and corresponding second logical values,
determine common attributes between the first semantic attributes and the second semantic attributes,
determine a physical asset associated with the first semantic asset and the second semantic asset, if said common attributes have similar values based on semantic and/or similarity comparison,
create an identifier for the determined physical asset associated with the common attributes and values for the common attributes in the semantic model,
update the semantic model with the physical asset and with relationship between the physical asset, the first semantic asset and the second semantic asset.

## Description

### FIELD OF INVENTION

The present invention generally relates to an infrastructure model like an industrial plant model for modelling plant items within an engineering environment.

### BACKGROUND

An infrastructure like a plant requires engineering in different domains (mechanical/Process/Electrical ...) with different disciplines per domain (Flow management, Hydraulic, Piping, Instrumentation for the process domain). Each domain or discipline is using dedicated model and tools to represent hardware or software assets. But there is no consistent model from one domain to the other, thus enforcing duplicated data, multiple import/export and high cost of engineering.

The infrastructure information is siloed by engineering discipline, each discipline relying on dedicated standards and data models, and cross-domain interactions have to rely on human expertise and exchanges.

Moreover, an existing infrastructure like a brown field plant requires a maintenance that is painful and ineffective. Indeed, the maintenance relies on human experience, on plant documentation that is either obsolete or not available in a domain specific format and the history of modification is missing.

There is therefore a need for an asset centric approach to easily exploit asset information from different engineering domains, including brown field engineering domains, for example for analytics and efficient maintenance.

### SUMMARY

This summary is provided to introduce concepts related to the present inventive subject matter. This summary is not intended to identify essential features of the claimed subject matter nor is it intended for use in determining or limiting the scope of the claimed subject matter.

In one implementation, there is provided a method for updating a semantic model of a plant infrastructure comprising physical assets that belong to different engineering domains, wherein applications are dedicated to the engineering domains, wherein physical assets are represented by first logical assets in updated applications and by second logical assets in outdated applications, the method comprising:
for at least one updated application, determining first logical attributes and corresponding first logical values of a first logical asset from first metadata associated with the first logical asset,
for at least one updated application, determining second logical attributes and corresponding second logical values of a second logical asset from second metadata associated with the second logical asset,
determining a first semantic asset with first semantic attributes and corresponding first semantic values using pattern-matching rules related to the semantic model on the first logical attributes and corresponding first logical values, and determining a second semantic asset with second semantic attributes and corresponding second semantic values using pattern-matching rules related to the semantic model on the second logical attributes and corresponding second logical values,
determining common attributes between the first semantic attributes and the second semantic attributes,
determining a physical asset associated with the first semantic asset and the second semantic asset, if said common attributes have similar values based on semantic and/or similarity comparison,
creating an identifier for the determined physical asset associated with the common attributes and values for the common attributes in the semantic model,
updating the semantic model with the physical asset and with relationship between the physical asset, the first semantic asset and the second semantic asset

Advantageously, the information on the infrastructure, like a production plant, is not only expressed from the engineering domain point of view but offers to the owner and operator of the plant an asset centric vision of the infrastructure, allowing access to information on the asset context related to different engineering domains, including brown field engineering domains.

Advantageously, the method provides a methodology to digitalize an existing plant asset model, across multiple engineering domain, by reverse engineering existing information (from existing documents) into a semantic model like a plant knowledge graph, interconnecting semantically plant assets across multiple domains. A real physical asset present in the plant can be associated to a semantic physical asset that is linked to a first semantic asset and a second semantic asset in the semantic model from a first logical asset in an updated application and from a second logical asset in an outdated application.

Advantageously a plant knowledge graph can be rebuilt from existing tool centric information in order to update and maintain a digital documentation of the plant, allowing to overcome turn over and aging people leaving in the plant. It also increases production efficiency in operation by reducing the plant downtime thanks to accurate root cause analysis and enables delivery of plant data semantic analysis for plant production optimisation. It also increases efficiency of plant renewal phase by recovering cross-domain information of asset in the plant.

Advantageously, engineering cost is reduced drastically for the end user by eliminating duplicated effort for every engineering domain. There is only one reference for a physical asset to be updated for example for operating and maintenance of the infrastructure.

In an embodiment, the method further comprises:
determining first logical asset relationships of the first logical asset and second logical asset relationships of the second logical asset,
determining first semantic asset relationships of the first semantic asset using pattern-matching rules related to the semantic model on the first logical asset relationships of the first logical asset and determining second semantic asset relationships of the second semantic asset using pattern-matching rules related to the semantic model on the second logical asset relationships of the second logical asset,
determining the physical asset associated with the first semantic asset and the second semantic asset if the first semantic asset and the second semantic asset further have at least one common asset relationship.

In an embodiment, the first metadata associated with the first logical asset are determined using a parsing tool on code of said at least one updated application and the second metadata associated with the second logical asset are determined using a parsing tool on code of said at least one outdated application.

In an embodiment, the first logical attribute is compared to a reference attribute of the semantic model and the first logical attribute is classified as the first semantic attribute corresponding to the reference attribute if the first logical attribute satisfies pattern-matching rules related to the semantic model, and the second logical attribute is compared to a reference attribute of the semantic model and the first logical attribute is classified as the second semantic attribute corresponding to the reference attribute if the second logical attribute satisfies pattern-matching rules related to the semantic model.

In an embodiment, the first semantic asset relationships of the first semantic asset are in the engineering domain of the updated application and the second semantic asset relationships of the second semantic asset are in the engineering domain of the outdated application.

In an embodiment, the first semantic asset relationships of the first semantic asset and the second semantic asset relationships of the second semantic asset are in different engineering domains.

In an embodiment, common semantic attributes between the first semantic asset and the second semantic asset are related to attributes comprising: the name of asset, the type of asset, the geolocation of asset.

In an embodiment, the first logical assets are labelled as trusted in updated applications and the second logical assets are labelled as untrusted in outdated applications, and the second logical asset is labelled as trusted once the physical asset is determined.

In an embodiment, the updated semantic model is provided for bringing up-to-date information related to the first semantic asset and related to the second semantic asset.

In an embodiment, the updated application is regularly updated and is an up-to-date application in use for the operation of the plant, and the outdated application is not updated and is a not up-to-date application that is not in use for the operation of the plant.

In an embodiment, asset relationships are categorized in at least two types of relationship including composition relationship and connection relationship, wherein composition relationship defines physical link between assets and connection relationship defines physical interaction between assets.

In an embodiment, the asset relationship is defined by a triple composed of one asset, a relationship and another asset.

In an embodiment, each engineering domain is associated with a domain ontology defining the format of the attributes and of the asset relationships.

Advantageously, the method allows to share engineering and asset information among different domains through dedicated applications and to move seamlessly from one application to another in asset context.

Advantageously, the model as a graph represents any kind of plant by modelling its various physical assets involved during all the lifecycle of the plant, from the engineering to operating and maintenance of the plant. The graph provides easy access to asset information from any view to any other view without expert knowledge. The graph also provides acceleration in diagnostic and decision making for equipment for example during operation and maintenance.

Advantageously, ontologies and semantic web technologies allow to reconcile the various discipline asset structures without imposing changes to these structures. This allows to create cross domain interoperability from design and build to operate and maintain phases with minimal effort.

Each asset is described in a plant knowledge graph using semantic web technology and has a simple web semantic property to launch different applications of interest: any software that may display a view of the asset. Each application can expose a mechanism to move easily between asset-related applications. Where possible, the invoked application can be opened in context to the asset of interest.

In another implementation, there is provided an application server for updating a semantic model of a plant infrastructure comprising physical assets that belong to different engineering domains, wherein applications are dedicated to the engineering domains, wherein physical assets are represented respectively by first logical assets in updated applications and respectively by second logical assets in outdated applications, the application server comprising:
means for determining, for at least one updated application, first logical attributes and corresponding first logical values of a first logical asset from first metadata associated with the first logical asset,
means for determining, for at least one outdated application, second logical attributes and corresponding second logical values of a second logical asset from second metadata associated with the second logical asset,
means for determining a first semantic asset with first semantic attributes and corresponding first semantic values using pattern-matching rules related to the semantic model on the first logical attributes and corresponding first logical values, and determining a second semantic asset with second semantic attributes and corresponding second semantic values using pattern-matching rules related to the semantic model on the second logical attributes and corresponding second logical values,
means for determining common attributes between the first semantic attributes and the second semantic attributes,
means for determining a physical asset associated with the first semantic asset and the second semantic asset, if said common attributes have similar values based on semantic and/or similarity comparison,
means for creating an identifier for the determined physical asset associated with the common attributes and values for the common attributes in the semantic model,
means for updating the semantic model with the physical asset and with relationship between the physical asset, the first semantic asset and the second semantic asset.

In another implementation, there is provided an apparatus for updating a semantic model of a plant infrastructure comprising physical assets that belong to different engineering domains, the apparatus comprising:
one or more network interfaces to communicate with a telecommunication network;
a processor coupled to the network interfaces and configured to execute one or more processes; and
a memory configured to store a process executable by the processor, the process when executed operable to:
   for at least one updated application, determine first logical attributes and corresponding first logical values of a first logical asset from first metadata associated with the first logical asset,
   for at least one updated application, determine second logical attributes and corresponding second logical values of a second logical asset from second metadata associated with the second logical asset,
   determine a first semantic asset with first semantic attributes and corresponding first semantic values using pattern-matching rules related to the semantic model on the first logical attributes and corresponding first logical values, and determining a second semantic asset with second semantic attributes and corresponding second semantic values using pattern-matching rules related to the semantic model on the second logical attributes and corresponding second logical values,
   determine common attributes between the first semantic attributes and the second semantic attributes,
   determine a physical asset associated with the first semantic asset and the second semantic asset, if said common attributes have similar values based on semantic and/or similarity comparison,
   create an identifier for the determined physical asset associated with the common attributes and values for the common attributes in the semantic model,
   update the semantic model with the physical asset and with relationship between the physical asset, the first semantic asset and the second semantic asset

In another implementation there is provided a computer-readable medium having embodied thereon a computer program for executing a method for updating a semantic model of a plant infrastructure comprising physical assets that belong to different engineering domains. Said computer program comprises instructions which carry out steps according to the method according to the invention.

### BRIEF DESCRIPTION OF THE FIGURES

The detailed description is described with reference to the accompanying figures. In the figures, the left-most digit(s) of a reference number identifies the figure in which the reference number first appears. The same numbers are used throughout the figures to reference like features and components. Some embodiments of system and/or methods in accordance with embodiments of the present subject matter are now described, by way of example only, and with reference to the accompanying figures, in which:
FIG. 1 shows a schematic block diagram of a communication system according to one embodiment of the invention for updating a semantic model of a plant infrastructure comprising physical assets that belong to different engineering domains;
FIG. 2 shows an example graph of a model of an infrastructure comprising assets belonging to different engineering domains according to one embodiment of the invention;
FIG. 3 illustrates an example of a physical asset determination from a first logical asset and a second logical asset;
FIG. 4 illustrates another example of a physical asset determination from a first logical asset and a second logical asset, using asset relationships;
FIG. 5 shows a flow chart illustrating a method for updating a semantic model of a plant infrastructure comprising physical assets that belong to different engineering domains according to one embodiment of the invention.

The same reference number represents the same element or the same type of element on all drawings.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

### DESCRIPTION OF EMBODIMENTS

The figures and the following description illustrate specific exemplary embodiments of the invention. It will thus be appreciated that those skilled in the art will be able to devise various arrangements that, although not explicitly described or shown herein, embody the principles of the invention and are included within the scope of the invention. Furthermore, any examples described herein are intended to aid in understanding the principles of the invention, and are to be construed as being without limitation to such specifically recited examples and conditions. As a result, the invention is not limited to the specific embodiments or examples described below, but by the claims and their equivalents.

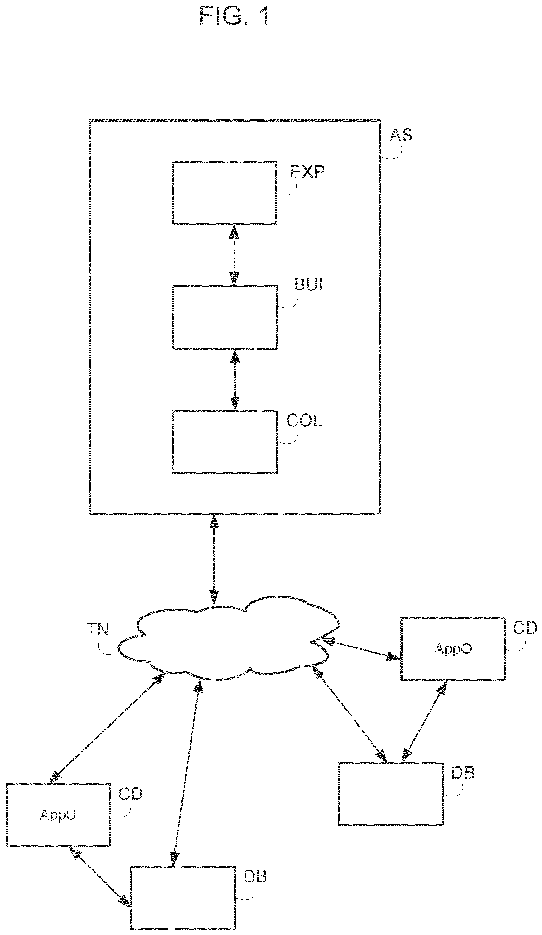

Referring to FIG. 1, an application server AS can communicate with databases DB respectively associated with different engineering domains that are related to a same infrastructure.

An engineering domain deals with a variety of implementation engineering frameworks (hydraulics, mechanics, electronics, electrical, communications) and can be managed by one or more dedicated applications that set the choice of appropriate architecture modelling frameworks and languages.

An infrastructure, such as a plant, comprises assets, like physical assets, that belong to different engineering domains. For example, a plant may present different engineering domains like a process engineering, automation engineering, electrical engineering, network engineering .... The process engineering manages process equipment as assets like robot, tank, pump, valve. The automation engineering manages automation equipment as assets like motor controller, IO module. The electrical engineering manages electrical equipment as assets like circuit breaker, switch gear. The network domain manages assets like Ethernet switches and routers.

An asset is an object that performs a job. Such an asset will be called a physical asset hereinafter, that can be a physical asset in real world or a cyber physical asset used in the cloud. For example, an asset can be a transmitter or a pipe or compound, eventually consisting of multiple sub-assets. An asset can be related to any number of other assets. An asset can define signals relating to dynamic, time-varying quantities - which are names and pointers to variables in the system. Such signals contain attributes to define units, ranges, etc... and can point to real-time data, historian time series, and/or simulated versions.

Furthermore, an asset presents a set of attributes, including standard and assettype specific (e.g. location, date of deployment). Some mandatory attributes can be a unique name and at least one class of equipment (e.g. Pump, motor, controller ...). For example, the attributes of an asset can include the following ones as it will be seen hereinafter: an asset identifier, an asset name, the engineering domain the asset belongs to, an URL (Universal Resource Location) pointing to a standard definition of the asset, a serial number.

It is assumed that one asset may be composed by different assets and thus inherits the attributes of the different assets.

In addition to attributes, each asset has at least one asset relationship with at least one other asset. It is assumed that there exist different kinds of asset relationship and all asset relationships can be categorized in at least two types of asset relationship: composition relationship and connection relationship. Composition relationship is pointing a sub-asset from which the asset is mechanically composed of. Connection relationship is pointing a connected asset. Assets may be connected through various kind of connection: electrical / mechanical / network / ... In other words, it can be also assumed that the composition relationship defines a link between two assets from physical point of view and a connection relationship defines an interaction between two assets from connection point of view

While composition and connection relationships are the core of a semantic model of the plant infrastructure like a knowledge graph, additional relationships may be added to provide more semantic and context to describe the assets. For example, the location of the asset can be added through a relationship "IsLocated".

The relationships between assets can be represented by a defined ontology based on triplets composed of subject, relation and object. The relation can be defined by a URI (Universal Resource Identifier), the subject can be an asset identifier and the object can be another asset identifier.

For example, according to the language of the defined ontology, the composition relationship comprises at least one of the following relations in a non-limiting way: hasPhysicalPart, isPhysicalPartOf, hosts, isHostedIn, hasLocation.

For example, according to the language of the defined ontology, the connection relationship comprises at least one of the following relations in a non-limiting way: hasPipingConnectionTo, isElectricallyConnectedTo, controls, monitors, communicatesWith.

For example, an agitator identified by the asset identifier TR1M01 is considered to be a physical part of a tank identified by the asset identifier TR1. The triplet corresponding to this composition relationship can be the following: (TR1, hasPhysicalPart, TR1M01).

For example, a current transformer identified by the asset identifier TC5 is considered to be electrically connected to a power transformer identified by the asset identifier PTR1. The triplet corresponding to this composition relationship can be the following: (TC5, isElectricallyConnectedTo, PTR1).

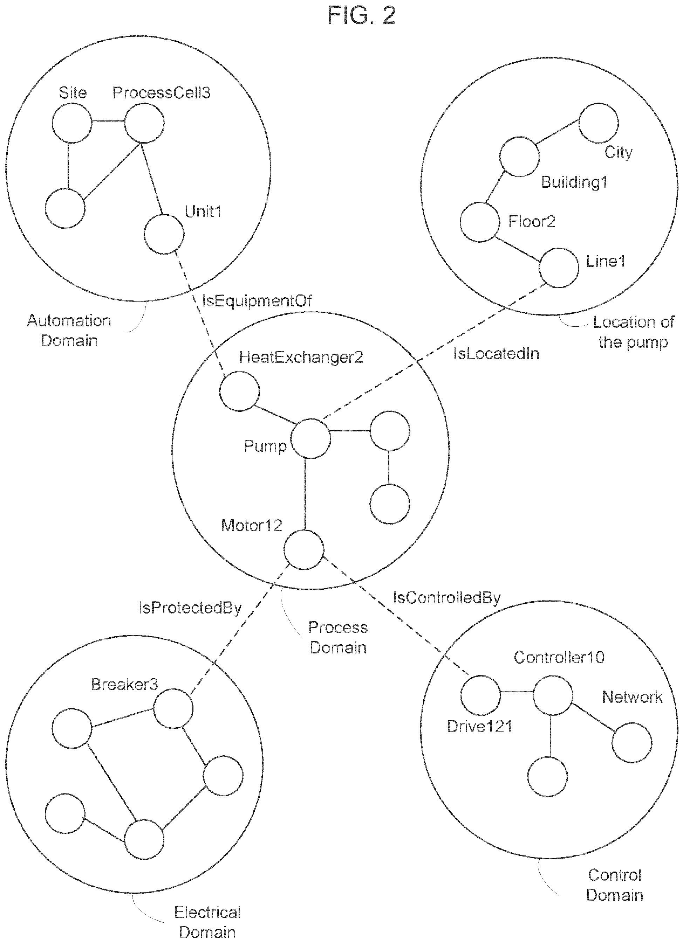

It is assumed that at least one asset belongs or is connected to at least two different engineering domains. For example, in reference to FIG. 2, the relationships between assets are represented by a semantic model under the form of a graph containing nodes corresponding to asset identifiers and edges corresponding to asset relationships between asset identifiers. An asset like a motor identified by Motor12 belongs to the "Process Domain", and is connected to both "Control Domain" and "Electrical Domain". The Process Domain contains at least assets like "Motor12", "Pump" and "HeatExchanger2". The "Automation Domain" contains at least assets like "Unit1", "ProcessCell3" and "Site". The "Control Domain" contains at least assets like "Drive121", "Controller10", while the "Electrical Domain" contains Breakers.

The asset Motor12 of the "Process Domain" has a connection relationship "IsProtectedBy" with the asset Breakers of the Electrical Domain and has a connection relationship "Iscontrolled" with the asset Drive121 of the "Control Domain".

Also in the "Process Domain", the asset HeatExchanger2 has a composition relationship "IsEquipmentOf' with the asset Unit1 of the Automation Domain". The asset Pump has another relationship "IsLocatedIn" with the asset Line1 of the engineering domain "Location of the pump".

The semantic model of the plant infrastructure can be seen as a knowledge graph which can express the links between a local schema, represented by the attributes of the assets, and the global schema, represented by the reference ontologies.

Referring back to FIG. 1, the application server AS can communicate with a set of communication devices CD through a telecommunication network TN. The telecommunication network may be a wired or wireless network, or a combination of wired and wireless networks. The telecommunication network can be associated with a packet network, for example, an IP ("Internet Protocol") high-speed network such as the Internet or an intranet, or even a company-specific private network.

In one embodiment for each engineering domain, a database DB associated with an engineering domain can store the sets of attributes of assets of the engineering domain and the relationships between the assets.

Each engineering domain is associated with at least one dedicated software application allowing access to attributes of assets of the engineering domain, and a set of services can be delivered by dedicated applications associated with engineering domains. Such dedicated applications can be implemented in communication devices CD that are accessible from the application server AS through the telecommunication network TN.

A software application dedicated to an engineering domain can be an updated application AppU or an outdated application AppO.

An updated application AppU is regularly updated and is an up-to-date application in use for the operation of the plant, i.e. currently in use during an operating phase or a maintaining phase of the plant. The assets handled by an updated application are called first logical assets and are labelled as trusted.

For example, an updated application is a control logic running application or is supervisory application (enabling asset operators to eliminate, minimize, or mitigate operational risk while optimizing asset performance).

An outdated application is not updated and is a not up-to-date application. An outdated application is not in use for the operation of the plant, but was used during a design phase for the plant. The assets handled by an outdated application are called second logical assets and are labelled as untrusted.

For example, an outdated application AppO is a piping and instrumentation diagram, or P&ID, showing the piping and related components of a physical process flow.

For updated applications, it is assumed that a common ontology is used across the different engineering domains as a general purpose vocabulary in terms of a reference dictionary or trusted dictionary, allowing interoperability between the updated applications across the different engineering domains. The language used for the naming of some attributes is thus recognized by the updated applications across the different engineering domains. Also the language used for the relationship between first logical assets across the different engineering domains satisfies a common model. In parallel, each engineering domain may use specific concepts (like a taxonomy for classifying assets) and a dedicated ontology for exploiting some attributes of the first logical assets of the engineering domain.

For outdated applications, it is assumed that no common ontology is used across the different engineering domains, with no interoperability between the outdated applications across the different engineering domains.

The language used for the naming of some attributes in one outdated application is only recognized by said outdated applications and not by other outdated applications or updated applications across the different engineering domains.

A first logical asset or a second logical asset can be seen as a facet that is engineering domain specific, with a naming convention, structuration and context specific to a facet application. For example, a physical asset like a pump can be used in an electrical domain, a process domain and a supervisory control domain. Thus for updated applications, this physical asset can be represented by first logical assets corresponding to a facet linked to a process domain tool (as a first updated application), a facet linked to a supervisory control tool (as a first updated application) and a facet linked to an electrical domain tool (as a first updated application). The same physical asset may also be represented by a second logical asset corresponding to a facet specific to an outdated application. Thus a physical asset can have a representation as facet in an updated application or outdated application, with information specific to the application but is not present in the semantic model.

In other words, a facet corresponds to a specific user concern (process, control infrastructure, supervision, etc...) and presents the infrastructure information in a display adapted to the customer concern (e.g. a plant hierarchy in a ISA88 view).

In one embodiment, some engineering domains may represent a hierarchy that can be made available to facets, with corresponding updated applications. A facet associated with a determined physical asset can permit access to a functional view of the physical asset in a functional hierarchy and another facet associated with the physical asset can permit access to a physical view of the physical asset in a physical hierarchy. In one example with a pump, a facet can permit to see that the pump is used in a milk doser in a milk processing in a north plant according to the functional hierarchy. In another example with the pump, a facet can permit to see that the pump is part of a motor in a rotating equipment of a process equipment according to the physical hierarchy.

In one embodiment, some first logical assets present properties allowing an exploitation of information by an updated application. In an updated application providing a graph, a facet is designed to extend the node corresponding to the physical asset by exposing data and functionalities from one or different engineering domains, eventually filtering and contextualizing them for the physical asset. By means of a facet and a dedicated updated application, an external system can then be able to access the physical asset information and eventually enrich it by publishing proper business logic results.

Referring again to FIG. 1, the application server AS includes a collector module COL, a builder module BUI and an exploitation module EXP.

The collector module COL is configured to retrieve information about first logical assets and second logical assets from different updated applications and outdated applications. The collector module COL is able to retrieve first metadata comprising first logical attributes and corresponding first logical values associated with a first logical asset from an updated application and is able to retrieve second metadata comprising second logical attributes and corresponding second logical values associated with a second logical asset from an outdated application. To that end, the collector module COL can use a parsing tool on code of said at least one updated application or outdated application.

According to the updated application or the outdated application, the first logical attributes and the second logical attributes may comprise same or different kinds of attributes.

For example, the first logical attributes or the second logical attributes comprise the following kind of attributes:
- Asset Tag Name
- Asset Type (e.g. pump, valve, Control PLC, Speed Controller, Digital Input /Output, Analog Input Switch Gear)
- Asset Domain (the same asset can be in a different engineering domains like a Motor in the Electrical, Process, Automation, I&T Network domains)
- Asset geolocation
- Asset Functional Hierarchy: Based on known Standard (e.g. ISA 88, ISA 106 , ISA 95).

For example, the first sets of attributes or the second sets of attributes comprise the following kind of attributes that are specific to an engineering domain:
Facet Tag Name (close to Asset Tag Name that can be inferred)
Facet Library Type Name (Correlated with to Asset Type that can be inferred
Intra-domain Facet Connections: (e.g. a pipe connection from P&ID, an electrical connection from SLD documentation).

The collector module COL creates a trusted dictionary of first logical assets, labelled as trusted, from the retrieved first metadata and creates an untrusted dictionary of second logical assets, labelled as untrusted, from the retrieved second metadata.

The way to retrieve the first logical attributes from first metadata and the second logical attributes from second metadata and the format of the first and second logical attributes from may depend on the kind of engineering domain it relates to. Some semantic rules linked to the semantic model can be applied to the retrieved first and second logical attributes, in order to be categorized in the same way.

Furthermore, the first logical attributes or the second logical attributes comprise asset relationships between assets. More especially, the first logical attributes comprise asset relationships between the first logical asset and other logical assets in the updated application, and the second logical attributes comprise asset relationships between the second logical asset and other logical assets in the outdated application.

The builder module BUI is further configured to determine first semantic attributes and corresponding first semantic values using pattern-matching rules related to the semantic model on the first logical attributes and corresponding first logical values. The builder module BUI can compare the current first logical attribute to a reference attribute of the semantic model and classify the first logical attribute as the reference attribute if the first logical attribute satisfies pattern-matching rules related to the semantic model, i.e. a schema or specific grammar of the semantic model. The same principle applies for the first logical value, and also for the second logical attribute and second logical value, to obtain respectively the first semantic value, and also for the second semantic attribute and second semantic value.

For some specific first logical value or second logical value, for example corresponding to an attribute of type "Name" or "localization", the value can be unique and this case the logical value is kept for the semantic value.

Thus the builder module BUI creates a first semantic asset, respectively a second semantic asset, from the first logical asset, respectively from the second logical asset. The builder module BUI updates the semantic model, more specifically the content of the knowledge graph like nodes, with the first semantic asset and the second semantic asset.

The builder module BUI is further configured to determine common attributes between the first semantic asset and the second semantic asset. In one example, a first logical attribute and a second logical attribute can have a similar format and designing the same property: "Asset Tag Name" and "Asset Identifier". After classification, the builder module BUI classifies the first logical attribute "Asset Tag Name" as first semantic attribute "AssetName" and the second logical attribute "Asset Identifier" also as second semantic attribute "AssetName" and thus determines that the first semantic asset and the second semantic asset have a common attribute ("AssetName").

The collector module COL is further configured to analyze the first metadata and the second metadata to determine first logical asset relationships of the first logical asset and second asset logical relationships of the second logical asset. As explained before, each of the first logical asset and the second logical asset has at least one relationship with at least one other logical asset. It is assumed that there exist different kinds of relationship and all relationships can be categorized in at least two types of relationship: composition relationship and connection relationship. The analysis of asset relationships is done first in the same engineering domain, i.e. in the engineering domain of the first logical asset and in the engineering domain of the second logical asset.

Once the first semantic asset, respectively the second semantic asset, are created from the first logical asset, respectively from the second logical asset, the builder module BUI is also able to determine first semantic asset relationships of the first semantic asset using pattern-matching rules related to the semantic model on first logical asset relationships of the first logical asset. The builder module BUI can compare a first logical asset relationship to a reference relationship of the semantic model and classify the first logical asset relationship as the reference attribute if the first logical asset relationship satisfies pattern-matching rules related to the semantic model, i.e. a schema or specific grammar of the semantic model. The same principle applies for the second logical asset relationships of the second logical asset, to obtain a second semantic asset relationships of the second semantic asset.

Also the builder module BUI updates the first semantic asset, respectively the second semantic asset, and thus the semantic model, with the first semantic asset relationship, respectively the second semantic asset relationship.

The builder module BUI is further configured to determine a physical asset associated with both the first semantic asset and the second semantic asset, if the common attributes have similar values based on semantic and/or similarity comparison.

More especially, the builder module BUI can check the values of all the common attributes between the first semantic asset and the second semantic asset. Based on a similarity comparison, the builder module BUI determines if at least two common attributes between the first semantic asset and the second semantic asset have similar values.

If the analysis of the common attributes is not sufficient to validate a physical asset, the builder module BUI may check if the first semantic asset and the second semantic asset have at least one common semantic asset relationship.

In one example, if the first semantic asset and the second semantic asset have similar values for the attribute related to the type of asset but do not have similar values for the attribute related to the name of asset the common attributes based on similarity comparison, only one attribute may not be sufficient to determine the physical asset. In this case, the builder module BUI checks the asset relationships of the first semantic asset and the second semantic asset to detect if the first semantic asset and the second semantic asset have at least one asset relationship in common in order to confirm the determination of the physical asset.

In another example, the physical asset is already determined and the builder module BUI checks the asset relationships of the first logical asset and the second logical asset in order to confirm the determined physical asset.

In one embodiment, the builder module BUI considers the asset relationships of the first logical asset that are in the engineering domain of the updated application and the asset relationships of the second logical asset that are in the engineering domain of the outdated application. The builder module BUI considers the other assets of said the engineering domains and thus performs an intra domain analysis

In one embodiment, the builder module BUI considers the asset relationships of the first logical asset and of the second logical asset that are in another engineering domain. The builder module BUI considers the other assets of said another engineering domain and thus performs an inter domain analysis.

It is assumed that the assets involved in the semantic asset relationships are valid, meaning that another semantic asset having an asset relationship with the second semantic asset is already trusted and identified as valid. In other words, said another semantic asset is already linked to a determined physical asset.

The builder module BUI is further configured to create an identifier for the determined physical asset that is associated with the determined common attributes and corresponding values, and with the determined common asset relationship.

The builder module BUI is further configured to update semantic model with the physical asset and with relationship between the physical asset, the first semantic asset and the second semantic asset.

The builder module BUI is then able to label the second semantic asset as trusted, as this latter is now linked to the first semantic asset, labelled as trusted, and to the determined physical asset.

The builder module BUI is configured to build a model for each engineering domain, the model comprising physical assets that are linked between them based on the asset relationships. For an engineering domain, such model is called an engineering domain model and is considered to be a set of data that can be accessed and exploited by one or more dedicated applications for example for analytics, operation or maintenance.

Furthermore, the builder module BUI is configured to determine physical assets that belong or are connected to at least two different engineering domain models and to link the models of said at least two different engineering domain models via said physical assets. In this way, the builder module BUI is able to link the different engineering domain models and thus to build a global semantic model for the infrastructure.

In one embodiment, the semantic model for the infrastructure provides a standardized architecture for the modelling of the hierarchies for the infrastructure assets which can be used by a plurality of different users that are in a business relation to the assets of the infrastructure.

In one embodiment, the engineering domain model corresponds to a domain knowledge graph, wherein nodes of the graph correspond to asset identifiers (or values of attributes of type "Name") and edges of the graph correspond to asset relationships between asset identifiers. It is assumed that the domain knowledge graph is a programmatic way to model a knowledge domain for example with the help of subject-matter experts, data interlinking, and machine learning algorithms.

The exploitation module EXP provides a set of services using sets of attributes associated with determined physical assets.

In one embodiment, the updated semantic model is provided by the exploitation module EXP for bringing up-to-date information related to the first logical asset and related to the second logical asset.

In one embodiment, the semantic model is represented by a graph and the exploitation module EXP provides a tool allowing a user to navigate in the graph to access different nodes and thus specific asset information in a given engineering domain.

In one embodiment, the exploitation module EXP provides a tool for analytics, for example for root cause analysis across engineering domains.

In one embodiment, each engineering domain is associated with at least one dedicated application, also called a tool, allowing access to information relating to the assets of the engineering domain by means of the sets of attributes associated with said physical assets. The exploitation module EXP connects the applications across the different engineering domains. Thus the exploitation module EXP allows the sharing of asset information among the different applications of the engineering domains.

An embodiment comprises an application server AS under the form of an apparatus comprising one or more processor(s), I/O interface(s), and a memory coupled to the processor(s). The processor(s) may be implemented as one or more microprocessors, microcomputers, microcontrollers, digital signal processors, central processing units, state machines, logic circuitries, and/or any devices that manipulate signals based on operational instructions. The processor(s) can be a single processing unit or a number of units, all of which could also include multiple computing units. Among other capabilities, the processor(s) are configured to fetch and execute computer-readable instructions stored in the memory.

The functions realized by the processor may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included.

The memory may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. The memory includes modules and data. The modules include routines, programs, objects, components, data structures, etc., which perform particular tasks or implement particular abstract data types. The data, amongst other things, serves as a repository for storing data processed, received, and generated by one or more of the modules.

A person skilled in the art will readily recognize that steps of the methods, presented above, can be performed by programmed computers. Herein, some embodiments are also intended to cover program storage devices, for example, digital data storage media, which are machine or computer readable and encode machine-executable or computer-executable programs of instructions, where said instructions perform some or all of the steps of the described method. The program storage devices may be, for example, digital memories, magnetic storage media, such as a magnetic disks and magnetic tapes, hard drives, or optically readable digital data storage media.

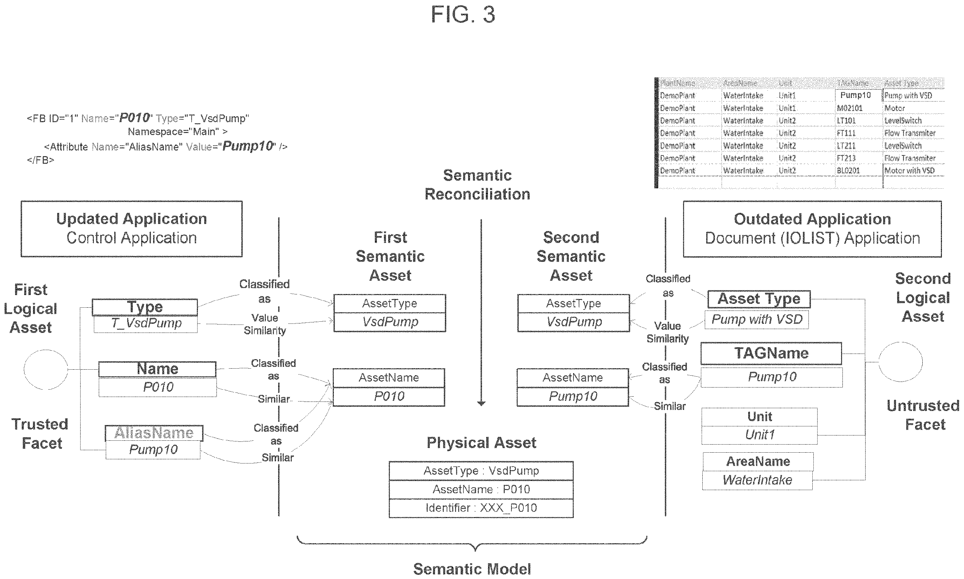

Referring to FIG. 3, there is illustrated an example of a physical asset determination from a first logical asset, labelled as a trusted facet, and a second logical asset, labelled as an untrusted facet.

As explained before, the collector module can use a parsing tool on code of a control application, as an updated application, and on code of a document IOLIST application, as an outdated application. For the outdated or the updated application, some metadata can be extracted from the code of the application, corresponding to types of attributes and values of these attributes.

For the updated application, the following types of first logical attributes are determined: "Type", "Name" and "AliasName"; having respectively the following first logical values "T_VsdPump", "P010" and "Pump10".

For the outdated application, the following types of second logical attributes are determined: "Asset Type", "TAGName", "Unit" and "AreaName"; having respectively the following second logical values "Pump with VSD", "Pump10", "Unit1" and "WaterIntake".

The builder module can then determine common attributes between the first logical asset and the second logical asset, based on a semantic comparison related to the semantic model. With a semantic reconciliation, the logical attributes "Type" and "Asset Type" are classified under the type of semantic attribute "Asset Type", and the logical attributes "Name" and "TAGName" are classified under the type of semantic attribute "Asset Name". In one embodiment, the logical attribute "AliasName" is also classified as "Asset Name". With a semantic reconciliation, the logical values "T_VsdPump" and "Pump with VSD" are classified under the same reference value "VsdPump", and the logical values "P010" and "Pump10" are classified by keeping the original values because this type of value is unique.

The builder module can update the semantic model by creating a first semantic asset, respectively a second semantic asset with the corresponding classified semantic attributes and values, from the first logical asset, respectively a second logical asset.

The builder module can then compare the values of the common attributes, using a semantic and/or similarity comparison. As the first semantic asset and the second semantic asset have similar values "T_VsdPump" and "Pump with VSD" for the common attribute "Asset Type" and similar values "P010" and "Pump10" for the common attribute "Asset Name", the builder module can determine a physical asset associated with both the first semantic asset and the second semantic asset and create an identifier for this physical asset. The physical asset is created and associated with the common attributes and corresponding values. For the unique value of the attribute "AssetName", one of the first semantic value and the second semantic value is taken (here "P010"). Moreover an identifier of the physical asset is created in order to uniquely identify this latter, the identifier being closed to the value of the attribute "AssetName" for example, here "XXX_P010".

Moreover, with a semantic reconciliation, the attributes "Asset Type" and "Asset Name" and "TAGName" are assigned with values "T_VsdPump" and "Pump10".

A similarity comparison can be based on the type of characters of a value, as a lexicographical similarity, whereas a semantic comparison can be based on the meaning of the value. Depending on the cases, both types of comparison can be used.

For another example, a semantic comparison can be used to determine that values "P10" and "HeaterPump10" are similar because "P10" always designates a pump in a specific domain.

In one example, the first semantic asset and the second semantic asset may have similar values for the attribute related to the type of asset but may not have similar values for the attribute related to the name of asset the common attributes based on similarity comparison.

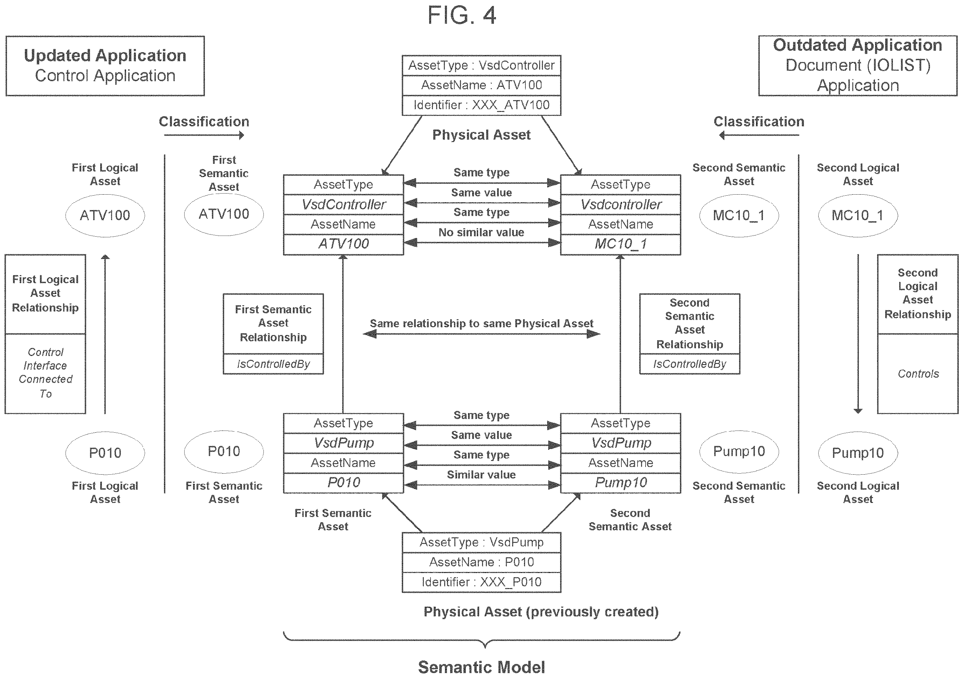

Referring to FIG. 4, there is illustrated another example of a physical asset determination from a first logical asset, labelled as a trusted facet, and a second logical asset, labelled as an untrusted facet, using asset relationships. This example uses some similar features of first logical asset and second logical asset from the previous example of FIG. 3 for better understanding.

The semantic model is updated in an iterative way and it is assumed that the physical asset from FIG. 3 with the attribute "AssetName" and value "P010" was already created. As explained previously, a first semantic asset was determined from the first logical asset identified by "P010" and a second semantic asset was determined from the second logical asset identified by "Pump10". As the first semantic asset and the second semantic asset have common attributes ("AssetType" and "AssetName") and same or similar values for these common attributes, the physical asset identified by the identifier "XXX_P010" has been created.

Furthermore, a first semantic asset is determined from the first logical asset identified by "ATV100", only the corresponding first semantic attributes and first semantic values are shown after having been classified. From the metadata of the updated application, the following first logical asset relationship was retrieved: (P010, ControlInterfaceConnectedTo, ATV100). This first logical asset relationship is classified as the following first semantic asset relationship: (P010, IsControlledBy, ATV100).

In a similar way, a second semantic asset is determined from the second logical asset identified by "MC10_1", only the corresponding second semantic attributes and second semantic values are shown after having been classified. From the metadata of the outdated application, the following second logical asset relationship was retrieved: (MC10_1, Controls, Pump10). This logical second asset relationship is classified as the following second semantic asset relationship: (Pump10, IsControlledBy, MC10_1).

For the first semantic asset "ATV100" and the second semantic asset "MC10_1", it is determined that they have common attributes "AssetType" and "AssetName". For the attribute "AssetType", they both have the same value "VsdController" but for the attribute "AssetName", they have different values "ATV100" and "MC10_1" and no similarity was found. So only with the common attributes and corresponding values, it could not be determined that there was a physical asset associated with first semantic asset "ATV100" and the second semantic asset "MC10_1".

As the physical asset "XXX_P010" is associated with the first semantic asset "P010" and the second semantic asset "Pump010", the first semantic asset relationship (P010, IsControlledBy, ATV100) is the same as (P010, IsControlledBy, ATV100) and the second semantic asset relationship (Pump10, IsControlledBy, MC10_1) is the same as (P010, IsControlledBy, MC10_1), using the value "P010" of the attribute "AssetName" of the physical asset.

By comparing the first semantic asset relationship and the second semantic asset relationship, it is determined that the first semantic asset and the second semantic asset have at least one common asset relationship with a same physical asset previously created, here the physical asset "XXX_P010".

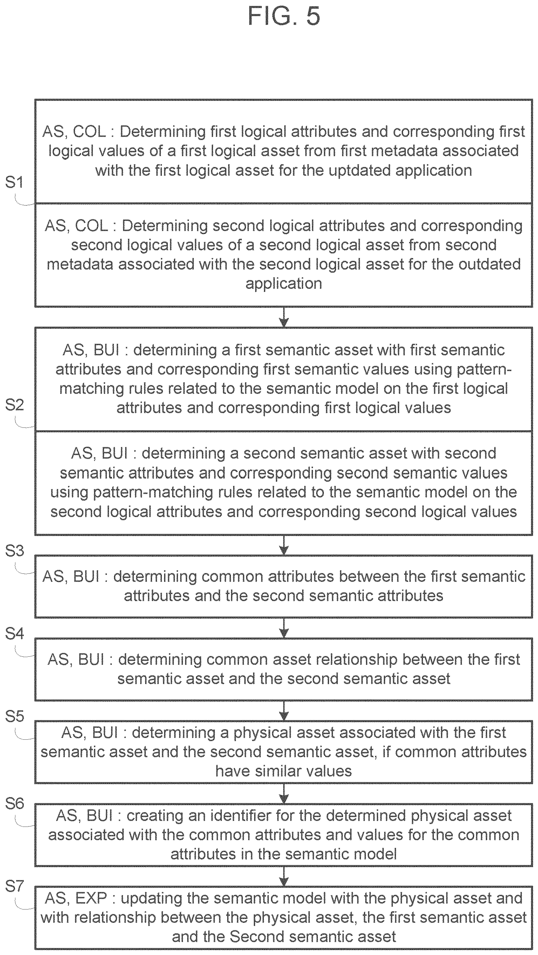

With reference to FIG. 5, a method for updating a semantic model of a plant infrastructure comprising physical assets that belong to different engineering domains according to one embodiment of the invention comprises steps S1 to S7. Applications are dedicated to the engineering domains, wherein physical assets are represented by first logical assets, labelled as trusted, in updated applications and by second logical assets, labelled as untrusted, in outdated applications.

In an example wherein the infrastructure is an industrial plant, the term physical asset as used herein generally refers to any equipment, instrument, groupings thereof, devices associated therewith, and the like, that are commonly employed in an industrial plant. A first logical asset or a second logical asset is associated with attributes corresponding to semantically meaningful elements that define the asset and that are based on a specific ontology.

In step S 1, the application server AS interrogates the communication devices CD implementing updated applications and outdated applications.

For at least one updated application, the collector module COL extracts first metadata of a first logical asset, using a parsing tool on code of said at least one updated application. The collector module COL determines first logical attributes and corresponding first logical values of the first logical asset from the first metadata associated with the first logical asset. Moreover, the collector module COL determines first logical asset relationships of the first logical asset (with other first logical assets).

For at least one updated application, in a similar manner, the collector module COL extracts second metadata of a second logical asset, using a parsing tool on code of said at least one outdated application. The collector module COL determines second logical attributes and corresponding second logical values of a second logical asset from second metadata associated with the second logical asset. Moreover, the collector module COL determines second logical asset relationships of the second logical asset (with other second logical assets).

In step S2, the builder module BUI determines a first semantic asset with first semantic attributes and corresponding first semantic values using pattern-matching rules related to the semantic model on the first logical attributes and corresponding first logical values, and also determines a second semantic asset with second semantic attributes and corresponding second semantic values using pattern-matching rules related to the semantic model on the second logical attributes and corresponding second logical values.

For example, the builder module BUI may categorize in the same way the first logical attributes into first semantic attributes, and second logical attributes into second semantic attributes, using semantic comparison on the attributes based on a domain ontology defining the format of the attributes. In a similar manner, the builder module BUI may categorize in the same way the first logical values into first semantic values, and second logical values into second semantic values, using semantic comparison on the attributes based on a domain ontology defining the format of the values.

In one embodiment, the builder module BUI can compare the first logical attribute to a reference attribute of the semantic model and classify the first logical attribute as a first semantic attribute corresponding to the reference attribute if the first logical attribute satisfies pattern-matching rules related to the semantic model. Similarly, the builder module BUI can compare the second logical attribute to a reference attribute of the semantic model and classify the second logical attribute as a second semantic attribute corresponding to the reference attribute if the second logical attribute satisfies pattern-matching rules related to the semantic model.

Moreover, the builder module BUI determines first semantic asset relationships of the first semantic asset using pattern-matching rules related to the semantic model on the first logical asset relationships of the first logical asset. In parallel, the builder module BUI determines second semantic asset relationships of the second semantic asset using pattern-matching rules related to the semantic model on the second logical asset relationships of the second logical asset.

The builder module BUI updates the semantic model with the first semantic asset and the second semantic asset.

In step S3, the builder module BUI analyzes the first semantic attributes and the second semantic attributes to determine common attributes between the first semantic asset and the second semantic asset.

In step S4, the builder module BUI determines common asset relationship between the first semantic asset and the second semantic asset, by comparing the first semantic asset relationships and the second semantic asset relationships.

In step S5, the builder module BUI determines a physical asset associated with both the first semantic asset and the second semantic asset, if said common attributes have similar values based on semantic and/or similarity comparison.

If the builder module BUI did not determine enough common attributes with similar values, i.e. the first values and the second semantic values are not considered similar according to a similarity algorithm, the builder module BUI determines the physical asset associated with the first semantic asset and the second semantic asset if the first semantic asset and the second semantic asset further have at least one common asset relationship.

In step S6, the builder module BUI creates an identifier for the determined physical asset associated with the common attributes and values for the common attributes in the semantic model.

In step S7, the exploitation module EXP updates the semantic model with the physical asset and with relationship between the physical asset, the first semantic asset and the second semantic asset. The semantic model now contains the information that the first semantic asset and the second semantic asset designate the same physical asset.

Step S 1 to S7 are iterative steps, allowing determination of physical assets and validation of associated second semantic asset as trusted, and allowing determination of asset relationships that are common for a first semantic asset and a second semantic asset with a same physical asset previously determined.

The physical asset in the semantic model is a semantic asset and allows to uniquely designate a real physical asset present in the plant and to link this later to a first (or second) semantic asset in the semantic model in a specific engineering domain. This real physical asset was only represented respectively by a first logical asset in an updated application and respectively by a second logical asset in an outdated application.

In one embodiment, the engineering domain model corresponds to a graph, wherein nodes correspond to asset identifiers and edges correspond to asset relationships between asset identifiers. The exploitation module EXP thus uses the engineering domain model to deploy a knowledge graph that can be used to navigate and visualize the relationships between physical assets, first semantic assets and second semantic assets. The knowledge graph represents a collection of interlinked entities that enhances the ability of a user to search for desired information. The knowledge graph can be represented in a database using LPG (Labeled Property Graph), RDF (Resource Description Framework), or similar graph models.

Although the present invention has been described above with reference to specific embodiments, it is not intended to be limited to the specific form set forth herein. Rather, the invention is limited only by the accompanying claims and, other embodiments than the specific above are equally possible within the scope of these appended claims.

Furthermore, although exemplary embodiments have been described above in some exemplary combination of components and/or functions, it should be appreciated that, alternative embodiments may be provided by different combinations of members and/or functions without departing from the scope of the present disclosure. In addition, it is specifically contemplated that a particular feature described, either individually or as part of an embodiment, can be combined with other individually described features, or parts of other embodiments.

## Claims

1. A method for updating a semantic model of a plant infrastructure comprising physical assets that belong to different engineering domains, wherein applications are dedicated to the engineering domains, wherein physical assets are represented by first logical assets in updated applications and by second logical assets in outdated applications, the method comprising:
for at least one updated application, determining (S1) first logical attributes and corresponding first logical values of a first logical asset from first metadata associated with the first logical asset,
for at least one updated application, determining (S1) second logical attributes and corresponding second logical values of a second logical asset from second metadata associated with the second logical asset,
determining (S2) a first semantic asset with first semantic attributes and corresponding first semantic values using pattern-matching rules related to the semantic model on the first logical attributes and corresponding first logical values, and determining a second semantic asset with second semantic attributes and corresponding second semantic values using pattern-matching rules related to the semantic model on the second logical attributes and corresponding second logical values,
determining (S3) common attributes between the first semantic attributes and the second semantic attributes,
determining (S5) a physical asset associated with the first semantic asset and the second semantic asset, if said common attributes have similar values based on semantic and/or similarity comparison,
creating (S6) an identifier for the determined physical asset associated with the common attributes and values for the common attributes in the semantic model,
updating (S7) the semantic model with the physical asset and with relationship between the physical asset, the first semantic asset and the second semantic asset.

2. A method according to any of previous claims, further comprising:
determining (S1) first logical asset relationships of the first logical asset and second logical asset relationships of the second logical asset,
determining (S2) first semantic asset relationships of the first semantic asset using pattern-matching rules related to the semantic model on the first logical asset relationships of the first logical asset and determining (S2) second semantic asset relationships of the second semantic asset using pattern-matching rules related to the semantic model on the second logical asset relationships of the second logical asset,
determining (S5) the physical asset associated with the first semantic asset and the second semantic asset if the first semantic asset and the second semantic asset further have at least one common asset relationship.

3. A method according to any of previous claims, wherein the first metadata associated with the first logical asset are determined using a parsing tool on code of said at least one updated application and the second metadata associated with the second logical asset are determined using a parsing tool on code of said at least one outdated application.

4. A method according to any of previous claims, wherein the first logical attribute is compared to a reference attribute of the semantic model and the first logical attribute is classified as the first semantic attribute corresponding to the reference attribute if the first logical attribute satisfies pattern-matching rules related to the semantic model, and the second logical attribute is compared to a reference attribute of the semantic model and the first logical attribute is classified as the second semantic attribute corresponding to the reference attribute if the second logical attribute satisfies pattern-matching rules related to the semantic model.

5. A method according to any of previous claims, wherein the first semantic asset relationships of the first semantic asset are in the engineering domain of the updated application and the second semantic asset relationships of the second semantic asset are in the engineering domain of the outdated application.

6. A method according to any of previous claims, wherein the first semantic asset relationships of the first semantic asset and the second semantic asset relationships of the second semantic asset are in different engineering domains.

7. A method according to any of previous claims, wherein common semantic attributes between the first semantic asset and the second semantic asset are related to attributes comprising: the name of asset, the type of asset, the geolocation of asset.

8. A method according to any of previous claims, wherein the first logical assets are labelled as trusted in updated applications and the second logical assets are labelled as untrusted in outdated applications, and further comprising labelling the second logical asset as trusted once the physical asset is determined.

9. A method according to any of previous claims, wherein the updated semantic model is provided for bringing up-to-date information related to the first semantic asset and related to the second semantic asset.

10. A method according to any of previous claims, wherein the updated application is regularly updated and is an up-to-date application in use for the operation of the plant, and the outdated application is not updated and is a not up-to-date application that is not in use for the operation of the plant.

11. A method according to any of previous claims, wherein asset relationships are categorized in at least two types of relationship including composition relationship and connection relationship, wherein composition relationship defines physical link between assets and connection relationship defines physical interaction between assets.

12. A method according to any of previous claims, wherein the asset relationship is defined by a triple composed of one asset, a relationship and another asset.

13. A method according to any of previous claims, wherein each engineering domain is associated with a domain ontology defining the format of the attributes and of the asset relationships.

14. An application server (AS) for updating a semantic model of a plant infrastructure comprising physical assets that belong to different engineering domains, wherein applications are dedicated to the engineering domains, wherein physical assets are represented respectively by first logical assets in updated applications and respectively by second logical assets in outdated applications, the application server (AS) comprising:
means (COL) for determining, for at least one updated application, first logical attributes and corresponding first logical values of a first logical asset from first metadata associated with the first logical asset,
means (COL) for determining, for at least one outdated application, second logical attributes and corresponding second logical values of a second logical asset from second metadata associated with the second logical asset,
means (BUI) for determining a first semantic asset with first semantic attributes and corresponding first semantic values using pattern-matching rules related to the semantic model on the first logical attributes and corresponding first logical values, and determining a second semantic asset with second semantic attributes and corresponding second semantic values using pattern-matching rules related to the semantic model on the second logical attributes and corresponding second logical values,
means (BUI) for determining common attributes between the first semantic attributes and the second semantic attributes,
means (BUI) for determining a physical asset associated with the first semantic asset and the second semantic asset, if said common attributes have similar values based on semantic and/or similarity comparison,
means (BUI) for creating an identifier for the determined physical asset associated with the common attributes and values for the common attributes in the semantic model,
means (EXP) for updating the semantic model with the physical asset and with relationship between the physical asset, the first semantic asset and the second semantic asset.

15. A computer-readable medium having embodied thereon a computer program for executing a method for updating a semantic model of a plant infrastructure comprising physical assets that belong to different engineering domains according to any of claims 1 to 13.
